# EUROPEAN PATENT SPECIFICATION

(11) **EP 0 926 933 B1**
(45) Date of publication and mention of the grant of the patent: **15.05.2002**
(21) Application number: 98403059.3
(22) Date of filing: 07.12.1998
(51) Int. Cl.: H05K 1/16, H01F 5/00

(54) **Multilayer high frequency electronic components**
Mehrschichtiger Hochfrequenzbauteil
Composants électroniques hautes fréquences multicouches

(30) Priority: 19.12.1997 JP 35028397
(43) Date of publication of application: 30.06.1999
(73) Proprietor: Murata Manufacturing Co., Ltd., Nagaokakyo-shi Kyoto-fu 617-8555 (JP)
(72) Inventor: Nosaka, Koji, c/o Intellectual Property Department, Nagaokakyo-shi, Kyoto-fu 617-8555 (JP)
(74) Representative: Joly, Jean-Jacques

(56) References cited:
- WO-A-97/12440

## Description

### BACKGROUND OF THE INVENTION

### 1. Field of the Invention

The present invention relates to multilayer high frequency electronic components, in particular, multilayer high frequency electronic components having an inductor incorporated therein, such as an LC filter which is incorporated in mobile communications equipment.

### 2. Description of the Related Art

Fig.9 shows the construction of a known multilayer LC filter 61. A signal line 80, which is to function as an inductor L, is constituted by one conductor pattern on the surface of a ceramic sheet 74. Capacitor conductors 83, 84 are formed on the surface of another ceramic sheet 76, while a common capacitor conductor 82 is formed on the surface of yet another ceramic sheet 77. The capacitor conductor 83 and the common capacitor conductor 82 constitute an input side capacitor C1 across the ceramic sheet 76. Similarly, the capacitor conductor 84 and the common capacitor conductor 82 also constitute an output side capacitor C2 across the ceramic sheet 76. In addition, ground conductors 81, 85 are formed on the surface of further ceramic sheets 72, 78. The signal line 80 and the conductors 81-85 are formed on the surface of the respective ceramic sheets 72, 74, 76-78 by, for example, a thick film printing method.

After the ceramic green sheets 71-78 of the above-mentioned constitution are laminated and press-fitted, they are integratedly baked to form a laminated body. An input outer electrode 62 and an output outer electrode 63 are formed on left and right sides, respectively (as viewed in Fig.9) of an end surface of the laminated body. The input outer electrode 62 is connected to the capacitor conductor 83 while the output outer electrode 63 is connected to the capacitor conductor 84. A relay outer electrode 64 and ground outer electrodes 65, 66 are formed on this end surface on the distal side of the laminated body. The relay outer electrode 64 is connected to the signal line 80 and the common capacitor conductor 82. The ground outer electrode 65 is connected to the signal line 80 and the ground conductors 81, 85, while the ground outer electrode 66 is connected to the ground conductors 81, 85. Ground outer electrodes 67, 68, 69 are formed on the side surface on the proximal side of the laminated body. The ground outer electrodes 67, 68, 69 are connected to the ground conductors 81, 85, respectively.

In the known multilayer LC filter 61 having the above-mentioned constitution, there is a problem that a satisfactory Q characteristic of the inductor cannot be obtained, for the reasons described below.
(1) The film thickness of the signal line 80 which is to function as the inductance is as low as 20-30 µm at its thickest part, even when it is formed using a thick film printing method capable of relatively increasing the film thickness. Thus, the resistance component of the signal line 80 is large, and an excellent Q characteristic of the inductor cannot be obtained.
(2) When high frequency current flows in the signal line 80, the density of the high frequency current is increased at the edge part of the signal line 80 due to the skin effect. Thus, the effective sectional area of the signal line 80 is reduced, and the resistance component of the signal line 80 is further increased.

The object of the present invention is to provide multilayer high frequency electronic components in which the resistance component of a signal line which is to function as an inductor is reduced.

### SUMMARY OF THE INVENTION

To achieve the above-mentioned object, the multilayer high frequency electronic component of the present invention is characterised in that the signal line which is to function as an inductor is constituted by at least two conductor patterns of the same shape but having different conductor width, and these at least two conductor patterns are continuously arranged in the thickness direction across the insulation layer.

By constituting the signal line which is to function as an inductor of at least two conductor patterns, the sectional area of the signal line becomes larger than the conventional value, and the resistance component of the signal line is reduced. Thus, the Q characteristic of the inductor is improved. Further, by using different conductor width for the different conductor patterns, the relative position of edge parts of each conductor pattern is deviated in the width direction of the conductor pattern, and the skin effect is suppressed. Thus, concentration of the high frequency current at the edge part is reduced, the effective sectional area of the signal line is increased, and the resistance component of the signal line is further reduced.

### BRIEF DESCRIPTION OF THE DRAWINGS

Further features and advantages of the present invention will become clear from the following description of preferred embodiments thereof, given by way of example, and illustrated in the accompanying drawings, in which:
FIG. 1 is an exploded perspective view illustrating one embodiment of multilayer high frequency electronic component of the present invention;
FIG. 2 is a perspective view of the appearance of the multilayer high frequency electronic component illustrated in FIG. 1;
FIG. 3 is a sectional view taken along the line III-III in FIG. 2;
FIG. 4 is an enlarged sectional view of the signal line indicated in Region A in FIG. 3:
FIG. 5 is an electric equivalent circuit of the multilayer high frequency electronic component illustrated in FIG. 2;
FIG. 6 is an enlarged sectional view of the signal line to illustrate another embodiment of multilayer high frequency electronic component of the present invention;
FIG. 7 is an enlarged sectional view of the signal line to illustrate yet another embodiment of multilayer high frequency electronic component of the present invention:
FIG. 8 is an enlarged sectional view of the signal line to illustrate still another embodiment of multilayer high frequency electronic component of the present invention; and
FIG. 9 is an exploded perspective view illustrating the constitution of a conventional multilayer high frequency electronic component.

### DESCRIPTION OF THE PREFERRED EMBODIMENTS

The preferred embodiments of the multilayer high frequency electronic components according to the present invention are explained referring to the attached drawings. The preferred embodiments are explained using an LC filter as an example of the multilayer high frequency electronic component.

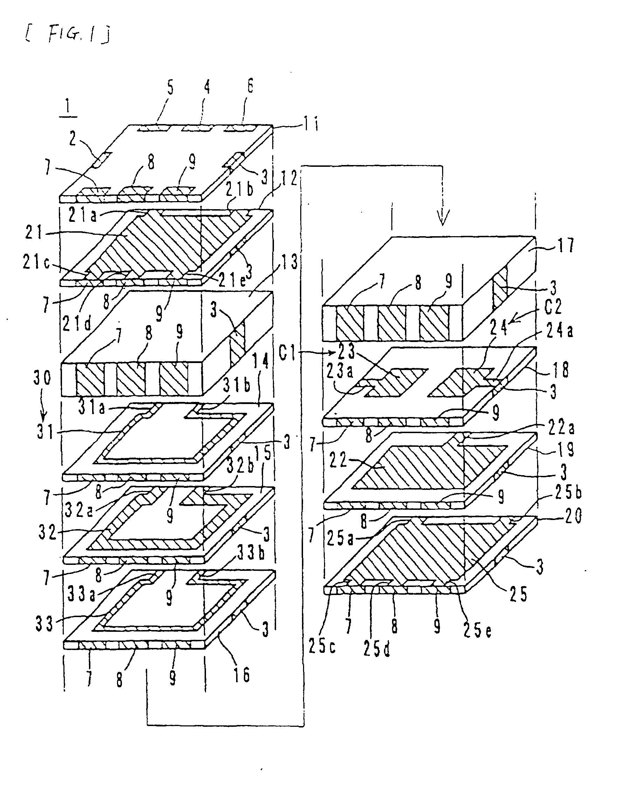

As indicated in FIG. 1, an LC filter 1 according to the first preferred embodiment of the invention comprises insulation sheets 12, 20 on the respective surfaces of which ground conductors 21, 25 are provided, further insulation sheets 14, 15, 16 on the respective surfaces of which conductor patterns 31, 32, 33 to constitute a signal line 30 are provided, another insulation sheet 18 on the surface of which capacitor conductors 23, 24 are provided, a still further insulation sheet 19 on the surface of which a common capacitor conductor 22 is provided, further insulation sheets 13, 17 for dummy, and a protective insulation sheet 11.

The signal line 30 functions as an inductor. The three conductor patterns 31, 32, 33 to constitute the signal line 30 are of the same shape, and arranged parallel to the outer circumference of the respective insulation sheets 14-16. One end parts 31a, 32a, 33a of the conductor patterns 31-33 are exposed at the left side of the distal edge of the sheets 14-16 (as viewed in Fig. 1 ). The other end parts 31b, 32b, 33b of the conductor patterns 31-33 are exposed at the centre part of the distal edge of the sheets 14-16, respectively. The conductor width of the conductor pattern 32 is set to be wider than that of the conductor patterns 31, 33.

The ground conductors 21, 25 are provided extending over the majority of the surface of the insulation sheets 12, 20, respectively. The ground conductors 21, 25 are used to prevent noise from being radiated from the LC filter 1 to the exterior, or to prevent noise from entering the LC filter 1 from the exterior. Lead parts 21a, 25a and lead parts 21b, 25b of the ground conductors 21, 25 are exposed at the left side and the right side of the distal edge of the sheets 12, 20, respectively. Lead parts 21c, 25c, lead parts 21d, 25d, and lead parts 21e, 25e of the ground conductors 21, 25 are exposed at the left side, the centre, and the right side on the proximal edge of the sheets 12, 20.

Lead parts 23a, 24a of capacitor conductors 23, 24 are exposed on the left side and the right side of the insulation sheet 18. A lead part 22a of the common capacitor conductor 22 is exposed at the centre of the distal edge of the insulation sheet 19. The capacitor conductor 23 and the common capacitor conductor 22 constitute an input side capacitor C1 across the sheet 18. Similarly, the capacitor conductor 24 and the common capacitor conductor 22 constitute an output side capacitor C2 across the sheet 18.

The conductor patterns 31-33 and the conductors 21-25 are formed by applying a conductive paste such as Ag, Ag-Pd or Cu to the sheets 12, 14-16, 18-20, and drying the paste using the thick film printing method or the like. The insulation sheets 11-20 are formed of a magnetic material such as ferrite, or a dielectric material such as ceramics material.

The insulation sheets 11-20 are laminated, and then, integratedly baked to form a laminated body 35 as indicated in FIG. 2. The input outer electrode 2 and the output outer electrode 3 are provided on the right and left sides of the laminated body 35 (as viewed in Fig.2). The relay outer electrode 4 and the ground outer electrodes 5, 6 are provided at the centre, the left, and the right of the distal side of the laminated body 35, respectively. The ground outer electrodes 7, 8, 9 are provided at the left, the centre, and the right of the proximal side of the laminated body 35.

The input outer electrode 2 and the output outer electrode 3 are electrically connected to the lead part 23a of the capacitor conductor 23 and the lead part 24a of the capacitor conductor 24. The relay outer electrode 4 is electrically connected to the end parts 31b, 32b, 33b of the conductor patterns 31, 32, 33, and the lead part 22a of the common capacitor conductor 22. The ground outer electrode 5 is electrically connected to the end parts 31a, 32a, 33a of the conductor patterns 31, 32, 33, and the lead parts 21a, 25a of the ground conductors 21, 25. The ground outer electrodes 6, 7, 8, 9 are electrically connected to the lead parts 21b, 25b, the lead parts 21c, 25c, the lead parts 21d, 25d, and the lead parts 21e, 25e of the ground conductors 21, 25. The electrodes 2-9 are formed by applying a conductive paste of Ag, Ag-Pd, Cu, Ni, etc., and then, baking it or performing dry plating thereof.

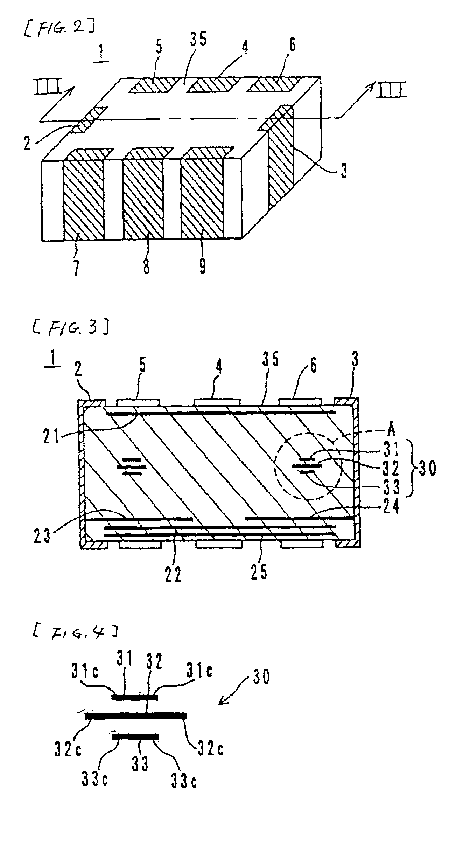

In the multilayer LC filter 1 of the above-mentioned constitution, the conductor patterns 31-33 to constitute the internal signal line 30 are continuously arranged in the thickness direction as indicated in FIG. 3. The conductor pattern 32 of large conductor width is arranged between the conductor patterns 31, 33 of small conductor width. FIG. 4 is an enlarged section of the signal line 30 indicated in Region A surrounded by the dotted line in FIG. 3. The edge part 32c on each side of the conductor pattern 32 is projected from the edge parts 31c, 33c on each side of the conductor patterns 31, 33. Because the signal line 30 to function as the inductor comprises three conductor patterns 31-33, the sectional area of the signal line 30 is increased compared with the conventional value, the resistance component of the signal line 30 can be reduced, and the Q characteristic of the inductor can be improved.

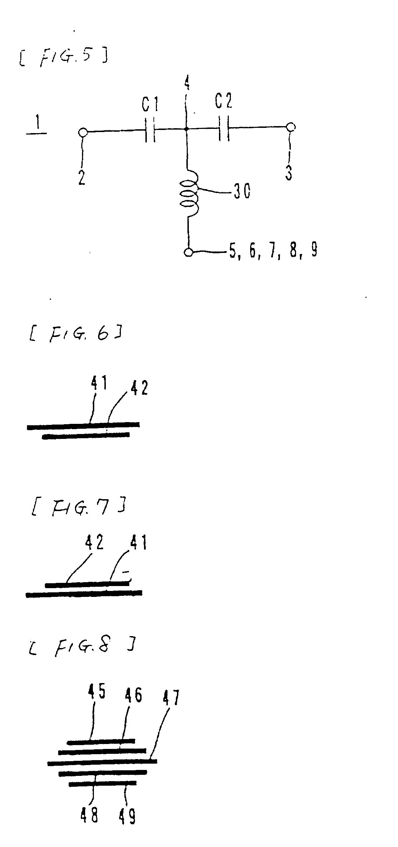

In addition, the edge part 32c on each side of the conductor pattern 32 can be projected from the edge parts 31c, 33c on each side of the conductor patterns 31, 33 by setting the conductor width of the conductor pattern 32 to be larger than the conductor width of the conductor patterns 31, 33. The skin effect at the edge part 32c of the conductor pattern 32 is suppressed thereby, and the phenomenon that the high frequency current flows at higher density at the edge parts 32c is mitigated. As a result, the sectional area of the signal line 30 can be increased, and the resistance component of the signal line 30 can be further reduced. As a result, a multilayer LC filter 1 with small insertion loss can be obtained. FIG. 5 is an electric equivalent circuit of the LC filter 1.

The multilayer high frequency electronic components of the present invention are not limited to the above-mentioned embodiment, but can be changed in various ways within the scope of the invention.

In the above-mentioned embodiment, an LC filter was taken as an example of the multilayer high frequency electronic components, but the invention is not limited thereto, but may provide inductor components, or high frequency electronic components having a strip line which constitutes the signal line having the inductor element.

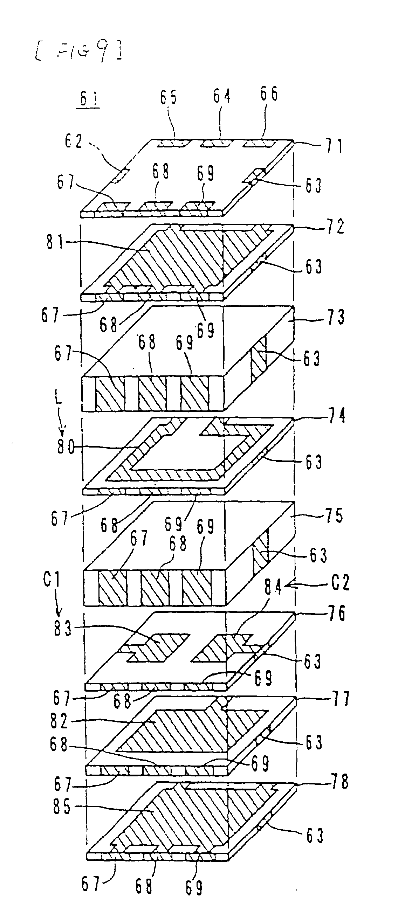

The number of the conductor patterns used to constitute the signal line may be two, as indicated in FIG. 6 and FIG. 7. In this case, the arrangement of the conductor pattern 41 of large conductor width and the conductor pattern 42 of small conductor width in the thickness direction may be varied.

In addition, the number of conductor patterns to constitute the signal line may be 4 or more. Fig.8 illustrates the case where 5 conductor patterns are used to constitute the signal line. As illustrated in FIG. 8, it is preferable that the conductor width of the conductor pattern 47 located at the centre in the thickness direction should be the greatest, and that the conductor width becomes successively smaller as the conductor patterns 45, 46, 48, 49 located above and below the conductor pattern 47 are farther away from the conductor pattern 47.

Further, in the first preferred embodiment, the ceramic sheets on which the electrodes are formed are laminated, and then, integratedly baked, but the invention is not limited to this practice. Preliminarily baked ceramic sheets may be used. Alternatively, the multilayer high frequency electronic components may be manufactured by the manufacturing method described below. After the ceramic layer is formed, of paste-like ceramic material, by a method such as printing, further paste-like conductive material is applied to the surface of the ceramic layer to form an arbitrary conductor pattern. Then, still further paste-like ceramic material is applied over the conductor pattern, in order to form a ceramic layer in which the conductor pattern is built in. Similarly, the high frequency electronic components having the lamination structure can be obtained by successively applying the ceramic material in an overlapping manner.

As clearly explained above, because in the present invention the signal line which is to function as an inductor is constituted by at least two conductor patterns, the sectional area of the signal line is increased compared with the conventional value, and the resistance component of the signal line can be reduced. Thus, the Q characteristic of the inductor can be improved. Further, by changing the conductor width of each conductor pattern, the relative position of the edge part of each conductor pattern is deviated in the width direction of the conductor pattern, and the skin effect at the edge part of the conductor pattern can be suppressed. Thus, concentration of the high frequency current at the edge part is reduced, the effective sectional area of the signal line is increased, and the resistance component of the signal line can be further reduced. As a result, multilayer high frequency electronic components with small insertion loss can be obtained.

## Claims

1. A multilayer high frequency electronic component with a built-in signal line (30) to function as an inductor, wherein said signal line (30) to function as the inductor is constituted by at least two conductor patterns (31-33) which have the same shape but different conductor width, and said at least two conductor patterns (31-33) are aligned with one another in the thickness direction across an insulation layer (14,15).

## Patentansprüche

1. Eine elektronische Mehrschicht-Hochfrequenz-Komponente mit einer eingebauten Signalleitung (30), um als ein Induktor zu funktionieren, bei der die Signalleitung (30), um als der Induktor zu funktionieren, aus zumindest zwei Leiterstrukturen (31-33) gebildet ist, die die gleiche Form, jedoch eine unterschiedliche Leiterbreite aufweisen, und die zumindest zwei Leiterstrukturen (31-33) in der Dickenrichtung über eine Isolierschicht (14, 15) miteinander ausgerichtet sind.

## Revendications

1. Composant électronique haute fréquence multicouche ayant une ligne de signal incorporée (30) destinée à faire fonction de bobine d'induction, où ladite ligne de signal (30) destinée à faire fonction de bobine d'induction est constituée par au moins deux motifs conducteurs (31-33) qui ont la même forme, mais des largeurs de conducteur différentes, et lesdits deux ou plus de deux motifs conducteurs (31-33) sont alignés l'un avec l'autre suivant la direction de l'épaisseur de part et d'autre d'une couche d'isolation (14,15).
